# EUROPEAN PATENT APPLICATION

(11) **EP 3 540 014 A1**
(43) Date of publication of application: **18.09.2019**
(21) Application number: 19162295.0
(22) Date of filing: 12.03.2019
(51) Int. Cl.: C09C 1/00

(54) **SOLVENT-LESS METHOD TO MANUFACTURE THIN FILM DEVICES**

(30) Priority: 14.03.2018 US 201862643038 P
(71) Applicant: Viavi Solutions Inc., San Jose, CA 95002 (US)
(72) Inventor: ARGOITIA, Alberto, Santa Rosa, CA California 95405 (US); LIANG, Kangning, Santa Rosa, CA California 95404 (US); SEYDEL, Johannes P., Petaluma, CA California 94952 (US); ZIEBA, Jaroslaw, Santa Rosa, CA California 95405 (US)
(74) Representative: Murgitroyd & Company

(57) **Abstract**

A method of forming a thin film device includes coating a web with a multi-layer thin film; and applying a mechanical force to release the multi-layer thin film from the web. Additional methods of forming a thin film device are disclosed.

## Description

### RELATED APPLICATION

The present application claims priority to U.S Provisional Application No. 62/643,038, filed on March 14, 2018, the disclosure of which is hereby incorporated by reference.

### FIELD OF THE INVENTION

The present disclosure generally relates to a method of forming a thin film device including coating a web with a multi-layer thin film; and applying a mechanical force to release the multi-layer thin film from the web.

### BACKGROUND OF THE INVENTION

Thin film devices are generally made on a web with a release layer between a multi-layer structure and the web. In some instances, the release layer is a sodium chloride release layer that is evaporated prior to coating the thin film device. In other instances, the release layer is an acetone soluble polymeric release layer provided by the polyethylene terephthalate web. In both instances, the thin film is stripped off in a wet process that dissolves the release layer using acetone/water or 100% acetone. The use of hazardous and flammable acetone (solvent) requires special process equipment for the stripping, rinsing, filtration, and drying of the as-stripped thin film.

A need exists for a method of removing a multi-layer structure from a web with a release layer, but without the use of caustic solvents, for example, a method using a simpler and less expensive dry process instead of current wet processes. Additionally, or alternatively, a need exists for a method of removing multi-layer structures from a web without a release layer. Such a method would be a simpler process and would be more cost effective because of the elimination of additional materials.

### SUMMARY OF THE INVENTION

In an aspect, there is disclosed a method of forming a thin film device including coating a web with a multi-layer thin film; and applying a mechanical force to release the multi-layer thin film from the web.

Optionally, the multi-layer thin film includes 3 layers.

Optionally, the multi-layer thin film includes a Fabry-Perot structure.

In another aspect, there is disclosed a method of forming a thin film device including coating a web with a first layer; coating the first layer with a reflector layer; coating the reflector layer with a second layer to form a multi-layer thin film; and releasing the multi-layer thin film from the web by a dry technique.

The method may further comprise collecting the released multi-layer thin film.

The method may further comprise grinding the released multi-layer thin film.

The first layer and/or the second layer may each independently be an organic layer or a composite organic/inorganic layer.

The dry technique may be an applied mechanical force creating a localized tension to crack the multi-layer thin film followed by application of a high velocity gas, air, or steam.

The dry technique may be an applied mechanical force of a localized ultrasonic application.

The dry technique may be an applied mechanical force of directly pulling the multi-layer thin film from the web.

The dry technique may be an applied mechanical force of stretching the multi-layer thin film while a vibrational force is applied.

The dry technique may be an applied mechanical force of vacuuming to strip the multi-layer thin film off the web by placing a vacuum blade in close proximity.

Optionally, each coating is independently applied using a process chosen from slot-die, gravure, microgravure, inkjet, curtain coating, metering rod, myer bar coating, flexo, and offset printing.

Optionally, each coating is independently applied using a process under vacuum chosen from physical vapor deposition and chemical vapor deposition.

The first layer and the second layer may be applied using a process chosen from slot-die, gravure, microgravure, inkjet, curtain coating, metering rod, myer bar coating, flexo, and offset printing, and the reflector layer is applied using a process under vacuum chosen from physical vapor deposition and chemical vapor deposition.

Optionally, the grinding may be a process chosen from jet mill, cryogenic grinding, ultrasonic grinding on liquid media, pulverizing, and high sheer wet grinding.

The first layer and/or the second layer may each independently include at least one of colorless particles, organic colorant pigments, organic colorant dyes, inorganic colored particles, organic absorber particles, inorganic absorber particles, organic high index dielectric particles, inorganic high index dielectric particles, organic low index dielectric particles, inorganic low index dielectric particles, inorganic metallic particles, inorganic composites, and inorganic alloys.

In a further aspect, there is disclosed a method of forming a thin film device including providing a web with a release layer; coating the release layer with a multi-layer thin film; and applying a mechanical force to release the multi-layer thin film from the web.

The release layer may be a water-soluble release layer.

Optionally, the multi-layer thin film includes a Fabry-Perot structure.

Optionally, the multi-layer thin film includes a first layer coated on the water-soluble release layer; and the method may further comprises coating the first layer with a reflector layer; and coating the reflector layer with a second layer to form the multi-layer thin film.

The release layer may be chosen from a polyvinyl alcohol formulation, a polysaccharide formulation, a polyacrylic acid formulation, a polyvinyl acetate formulation, a polyvinyl pyrrolidone formulation, a carboxymethyl cellulose formulation, and combinations thereof.

Additional features and advantages of various embodiments will be set forth, in part, in the description that follows, and will, in part, be apparent from the description, or may be learned by the practice of various embodiments. The objectives and other advantages of various embodiments will be realized and attained by means of the elements and combinations particularly pointed out in the description herein.

### BRIEF DESCRIPTION OF THE DRAWINGS

The present disclosure in its several aspects and embodiments can be more fully understood from the detailed description and the accompanying drawings, wherein:
Fig. 1 illustrates a transfer method for performing an aspect of the method, according to an example of the present disclosure;
Fig. 2 is a cross-sectional view of a thin film device, according to an example of the present disclosure;
Fig. 3 is a cross sectional view of a thin film device, according to an example of the present disclosure;
Fig. 4 is a cross sectional view of a thin film device, according to an example of the present disclosure; and
Fig. 5 is a cross sectional view of a thin film device, according to an example of the present disclosure.

Throughout this specification and figures like reference numbers identify like elements.

### DETAILED DESCRIPTION OF THE INVENTION

It is to be understood that both the foregoing general description and the following detailed description are exemplary and explanatory only, and are intended to provide an explanation of various embodiments of the present teachings. The layers/components shown in each Figure may be described with regard to a particular Figure, but it is understood that the description of a particular layer/component would be applicable to the equivalent layer/component in the other Figures.

In its broad and varied embodiments, there is disclosed a method for forming a thin film device 10 including coating a web 40 with a multi-layer thin film 20; and applying a mechanical force to release the multi-layer thin film 20 from the web 40. In an aspect, the web 40 does not include a release layer 30 and the multi-layer thin film 20 is deposited directly onto the web 40. The multi-layer thin film 20 can include two or more layers, such as 3 layers, 4 layers, 5 layers, or 6 or more layers, for example, 7 layers. In an aspect, the multi-layer thin film 20 can include 3 layers. In another aspect, the multi-layer thin film 20 can include 5 layers. The multi-layer thin film 20 can include a Fabry-Perot structure. A Fabry-Perot structure can have 5 or more layers to provide a thin film interference effect. The number of layers present in the Fabry-Perot structure can vary depending upon the desired optical properties, but also other properties, for example, magnetic properties. The method can be used to make thin film devices 10, such as special effect pigments. The layers comprising the multi-layer thin film 20 are discussed more fully below.

In an aspect, a method of forming a thin film device 10 can include coating a web 40 with a first layer; coating the first layer with a reflector layer; coating the reflector layer with a second layer to form a multi-layer thin film 20; and releasing the multi-layer thin film 20 from the web 40 by a dry technique. In an aspect, the web 40 does not include a release layer 30 and the multi-layer thin film 20, such as the first layer, is deposited directly onto the web 40. The method can further include collecting the released multi-layer thin film 20. The method can further include grinding the released multi-layer thin film 20. The first layer, reflector layer, and second layer are discussed more fully below.

In another aspect, there is disclosed a method of forming a thin film device 10 including providing a web 40 with a release layer 30; coating the release layer 30 with a multi-layer thin film 20; and applying a mechanical force to release the multi-layer thin film 20 from the web 40. In an aspect, the multi-layer thin film 20 can include 3 layers. In another aspect, the multi-layer thin film 20 can include 5 layers. The multi-layer thin film 20 can include a Fabry-Perot structure. A Fabry-Perot structure can have 5 or more layers to provide a thin film interference effect. The number of layers present in the Fabry-Perot structure can vary depending upon the desired optical properties, but also other properties, for example, magnetic properties. The method can be used to make thin film devices 10, such as special effect pigments. The layers comprising the multi-layer thin film 20 are discussed more fully below. In an aspect, the multi-layer thin film 20 coated on the release layer 30 can include a first layer coated on the release layer 30; coating the first layer with a reflector layer; and coating the reflector layer with a second layer to form the multi-layer thin film 20. The first layer, reflector layer, and second layer are discussed more fully below.

The web 40 used in the methods disclosed herein can be any material that can hold at least one of a release layer 30 and a multi-layer thin film 20. In an aspect, the web 40 can be a microstructured web 40, such as polyethylene terephthalate (PET). The web 40 can be flexible. In some aspects, the web 40 can include a release layer 30. In other aspects, the web 40 can be absent a release layer 30, such that a multi-layer thin film 20, for example, a first layer, can be coated directly onto the web 40.

The release layer 30 used in some of the methods disclosed herein can be provided on a surface the web 40 with a low adhesion to the web 40. In an aspect, the release layer 30 can be present with a lower adhesion to a first layer of the multi-layer thin film 20 as compared to the low adhesion to the web 40. In this manner, the release layer 30 can more easily be removed from the web 40 instead of the first layer of the multi-layer thin film 20. In an aspect, the release layer 30 can be water soluble. The release layer 30 can be eliminated from the multi-layer thin film 20 after a grinding process and before a passivation/functionalization wet process, for example, as used with pigments containing metallic layers, such as aluminum. A dry technique, such as a dry stripping process, can be done without the presence of a release layer 30 or can be done with a release layer 30 having a low adhesion to the web 40. A release layer 30 does not need to be present between the web 40 and the multi-layer thin film 20.

The release layer 30 can be chosen from polyvinyl alcohol formulation, polysaccharide formulation (dextran), polyacrylic acid formulation, polyvinyl acetate formulation, polyvinyl pyrrolidone formulation, carboxymethyl cellulose formulation and combinations thereof. The release layer 30 can be water soluble but insoluble to solvents used to coat the multi-layer thin film 20, including the first layer, the reflector layer, and the second layer. Additionally, the molecular mass of the release layer 30 can be altered to improve the solubility in water. For example, if the first layer has a water-based formulation, then the release layer 30 should have a low solubility in water. The release layer 30 should maintain its integrity for a period of time required for the coating and drying of at least the first layer of the multi-layer thin film 20.

In an aspect, the release layer 30 can be a polyvinyl alcohol (PVA) formulation. This formulation is nontoxic, clear, and inert. It is a water soluble polymer with excellent film-forming properties. A coating of PVA has a low adhesion to surfaces of hydrophobic polymers, such as polyethylene phthalate (PET), and is insoluble in most organic solvents. When one or multiple solvent-borne layers are coated onto a PVA layer pre-coated on a hydrophobic polymer sheet (web), the PVA layer not only remains intact during the coating process but also enables the layers to be conveniently separated from the polymer sheet (web) by the application of a mechanical force, such as an impact from a compressed air or water stream. In this manner, the PVA layer can function as a release layer 30.

PVA layers can be formed by coating an aqueous PVA solution onto the web 40. Both fully hydrolyzed and partially hydrolyzed (e.g., 86-88% hydrolyzed) PVA can be used to form a release layer 30. Furthermore, PVA with a molecular weight ranging from Mw 10,000 to 200,000 can be suitable for a release layer 30. Partially hydrolyzed PVA can lead to clear coatings and high solubility in cold water while fully hydrolyzed PVA can result in stiffer coatings due to its strong intramolecular hydrogen-bonding interaction. A low molecular weight can enable fast water dissolution and low solution viscosity. To the contrary, high molecular weight can result in slow water dissolution and high solution viscosity.

A formulation with 0.01% to 30% PVA can be used to coat the web 40 and to form a release layer 30. In addition to PVA, additives such as a surfactant, a deforming agent, an organic solvent, an antifouling agent, etc. can be included in the formulation forming the release layer 30 to enhance the coating performance. An effective PVA release layer 30 can have a layer thickness ranging from about 1 nm to about 10 microns, for example, from about 50 nm to about 1100 nm, depending on the properties of the web 40.

The PVA can be crosslinked at room temperature or an elevated temperature by a crosslinker. Suitable crosslinkers include, but are not limited to, dialdehydes such as glyoxal and glutaraldehyde; dicarboxylic acids such as malonic acid, succinic acid, glutaric acid, adipic acid, etc.; boric acid; and some multivalent metal ions such as Al³⁺. Crosslinking of the PVA layer can render it insoluble in water and able to function as a release material for water-borne coatings.

In an aspect, a polyacrylic acid (PAA)-PVA mixture can be used as a release layer 30. The mixture's adhesion to the web 40 can be adjusted by adding a base, such as sodium hydroxide to control the content of neutralized carboxylic acid groups. When PAA reacts with sodium hydroxide it forms sodium carboxylate salt. It has been found that the adhesion of a PAA-PVA release layer 30 to the web 40 can decrease as the content of the carboxylic salt content increases. In this manner, it is possible to tune the release of the multi-layer thin film 20 by controlling the amount of carboxylate salt in the release layer 30.

The release layer 30 can include inorganic salts and/or organic salts. Non-limiting examples of suitable salts for use in the release layer 30 include sodium chloride, sodium sulfate, potassium chloride, sodium acetate, and combinations thereof. The salts can modify properties of the release layer 30 and can reduce the adhesion between the release layer 30 and the web 40.

The multi-layer thin film 20 can include at least one of a first layer, a reflector layer, a second layer, and additional layers, such as absorbing layer and/or magnetic layers. The additional layers can be located in various positions within the multi-layer thin film 20. For example, the multi-layer thin film 20 can include a Fabry-Perot structure, such as an absorbing layer/a dielectric layer/reflector layer/dielectric layer/absorber layer.

In the disclosed methods, the first layer and the second layer can each independently be an organic layer or a composite organic/inorganic layer. The first layer and the second layer can each independently include at least one of colorless particles, organic colorant pigments, organic colorant dyes, inorganic colored particles, organic absorber particles, inorganic absorber particles, organic high index dielectric particles, inorganic high index dielectric particles, organic low index dielectric particles, inorganic low index dielectric particles, inorganic metallic particles, inorganic composites, and inorganic alloys. The molecules and/or particles of the first layer and the second layer can have a size that does not create Mie scattering, which can be produced when the molecules or particle size is larger than the wavelength of the incident light. This is in contrast with Rayleigh scattering which is the case when the wavelength of the incident light is larger than the particle size.

Non-limiting examples of inorganic high index dielectric particles and inorganic low index particles include SiO₂, TiO₂, Al₂O₃, ZrO₂, WO₃, VO₅, ITO, Ta₂O₅, CeO₂, Y₂O₃, ZnS, ZnO, In₂O₃, La₂O₃, MgO, Nd₂O₃, Pr₆O₁₁, Fe₂O₃, Fe₃O₄, SiO, SnO₂, FeOx, MgF₂, AlF₃, CeF₃, LaF₃, LiF, CaF₂, TiC, TiN, cermets, diamond-like carbon, metal carbides, metal nitrides, metal borides, metal carbonitrides, metal oxycarbides, metal oxynitrides, metal oxycarbonitrides, boron carbides, and combinations of them.

Non-limiting examples of organic absorber particles and inorganic absorber particles include carbon, graphite, silicon, germanium, cermets, metals mixed in a dielectric matrix, and other substances that are capable of acting as a uniform or selective absorber in the visible spectrum. Cermets and different alloys, such as Inconel, stainless steel, hastelloys, etc., can also be used for their optical and physical properties. Some metal carbides, metal nitrides, metal borides, metal carbonitrides, metal oxycarbides, metaloxynitrides, metal oxycarbonitrides can also be used for their absorbing properties when embedded in an organic matrix.

The first layer and/or the second layer can include organic monomers and polymers that can be used acrylates (e.g., methacrylate), epoxies, perfluoroalkenes, polytetrafluoroethylene (Teflon), fluorinated ethylene propylene (FEP), polyesters, polyvinyls, polyamides, polyimides, polyurethanes, polyacrylates, polymethacrylates, polycarbonates, polyureas, cellulose acetate butyrate, cellulose acetate propionate, cellulose nitrate, and combinations thereof.

The first layer and/or the second layer can include inorganic dielectric particles to change not only the visual appearance but also other functionalities of the final thin film pigment flake. Functional properties originated by the addition of inorganic particles include, but are not limited to, electrical and/or magnetic properties, fluorescent properties, up-converting properties (for example, converting a near-infrared laser beam into a visible light or turning low-energy colors of light, such as red, into higher-energy colors, like blue or green), flame retardant, and electrostatic dissipation.

Non-limiting examples of organic colorant pigments and organic colorant dyes include perylene, perinone, quinacridone, quinacridonequinone, anthrapyrimidine , anthraquinone, anthanthrone, benzimidazolone, disazo condensation, azo, quinolones, xanthene, azomethine, quinophthalone, indanthrone, phthalocyanine, triarylcarbonium, dioxazine, aminoanthraquinone, isoindoline , diketopyrrolopyrrole, thioindigo, thiazineindigo, isoindoline, isoindolinone, pyranthrone, isoviolanthrone, miyoshi methane, triarylmethane, vat dyes, sulfur dyes, and mixtures thereof.

The multi-layer thin film 20 can include a first layer epoxy, an acrylate, or an epoxy-acrylate hybrid coating on a PVA-PET. The first layer can be coated using a slot die coater or drawdown coater using solvent-borne formulations. In an aspect, this first layer can be successfully stripped from the PET web 40 by an applied mechanical force, such as an air stripping method.

In a further aspect, the multi-layer thin film 20 can include an all dielectric thin film interference structure including designs, such as (HL)ₙ, (LH)ₙ, (HL)ₙH, (LH)ₙL, and combinations thereof, wherein n is an integer from about 1 to about 100, such as from about 2 to 4. The L and H layers are each a QWOT at a selected design wavelength. Other suitable designs can also be obtained by the combination of high and low dielectric coatings with different optical thicknesses, and in some designs, some layers might not have a QWOT of the same wavelength. Similarly, some optical design might be symmetrical.

The multi-layer thin film 20, including the first layer, second layer, reflector layer, and additional layer can be deposited using a deposition process. In an aspect, each layer can independently be applied as a coating using a process chosen from slot-die, gravure, microgravure, inkjet, curtain coating, metering rod, myer bar coating, flexo, and offset printing. In another aspect, each layer can be independently applied as a coating using a process under vacuum chosen from physical vapor deposition and chemical vapor deposition. In a further aspect, the first layer and the second layer can be applied using a process chosen from slot-die, gravure, microgravure, inkjet, curtain coating, metering rod, myer bar coating, flexo, and offset printing; and the reflector layer is applied using a process under vacuum chosen from physical vapor deposition and chemical vapor deposition.

The reflector layer of the multi-layer thin film 20 can be deposited under vacuum. The reflector layer can include any material with reflecting properties, such as a metal. Non-limiting examples of a material with reflecting properties include aluminum, silver, copper, gold, platinum, tin, titanium, palladium, nickel, cobalt, rhodium, niobium, chromium, and compounds, combinations or alloys thereof. Non-limiting examples of other suitable reflective alloys and compounds include bronze, brass, titanium nitride, and the like, as well as alloys of the metals listed above such as silver-palladium. The reflector layer can have an inherent color, such as copper, gold, silver copper alloys, brass, bronze, titanium nitride, and compounds, combinations or alloys thereof.

The reflector layer can also include particles with reflecting properties incorporated into an organic matrix. The same materials described for the reflector layer deposited under vacuum can be used as additive particle into a suitable organic matrix. Furthermore, a silver reflector layer can be deposited using a variant of the Brashear silver process.

Special effect pigments based on a reflector layer including aluminum can be further processed using a passivation treatment to avoid oxidation of the aluminum layer.

The multi-layer thin film 20 can include independently in each of the first layer, reflector layer, second layer, and/or additional layers cohesive and adhesion promoter materials. These materials can be added directly to each layer or to the interfaces of the multi-layer thin film 20. Suitable adhesion promoters include, but are not limited to, molecules and resins containing hydroxyl, thiol, amine, carboxylic acid, phosphoric acid, or siloxane groups.

The methods disclosed herein can include using a dry technique, such as applying a mechanical force to release the multi-layer thin film 20 from the web 40 and/or the web 40 with a release layer 30, if present. In an aspect, the application of the mechanical force can cause the multi-layer thin film 20 to form flakes that can be released, and further processed. In another aspect, the application of mechanical force does not form flakes but free-standing thin film devices 10with specific optical and functional designs.

The applied mechanical force can include a localized tension to crack the multi-layer thin film 20 to form flakes. In an aspect, the localized tension can be assisted by a sharp knife in contact with the back of the web 40. The applied localized tension can be followed by application of a high velocity gas, air, or steam. In particular, an air stripping process can include (1) applying tension to the web 40 to induce cracks in the multi-layer thin film 20 to form thin film devices, such as flakes, and (2) applying a compressed air stream against the multi-layer thin film 20 to blow off the flakes of the multi-layer thin film 20 from the web 40.

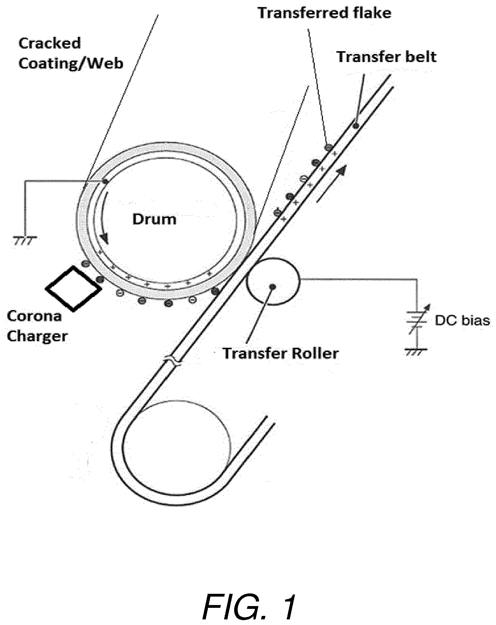

In another aspect, the applied mechanical force can include a localized ultrasonic application. In another aspect, the applied mechanical force can include pulling directly the multi-layer thin film 20 from the web 40. The applied mechanical force can also include stretching the multi-layer thin film 20 while a vibrational force is applied. The applied mechanical force can also include vacuuming to strip the multi-layer thin film 20 off the web 40 by placing a vacuum blade in close proximity to the multi-layer thin film 20 to suck it off the web 40 into a collection chamber. The collection of the thin film devices, such as flakes, can be achieved by a thin film device transfer method such as the one shown in FIG. 1.

The released multi-layer thin film 20 can be further processed, such as collected and/or ground. In an aspect, the released multi-layer thin film 20 is in a form of a flake that can be collected, such as collected into a cyclone by an appropriate air-flow venting system. The collected flakes can be ground. The grinding can be a process chosen from jet mill, cryogenic grinding, ultrasonic grinding on liquid media, pulverizing, and high sheer wet grinding. The flakes can then be rinsed and/or dried. In an aspect, a drying step is not necessary because some aluminum passivation processes require water, such as sodium dodecyl phosphonate, octylphosphonic acid, octadecylphosphonic acid, potassium dodecyl phosphate, and sol-gel encapsulation treatments with materials such as silica, titania, zirconia, ceria, alumina or combinations of them).

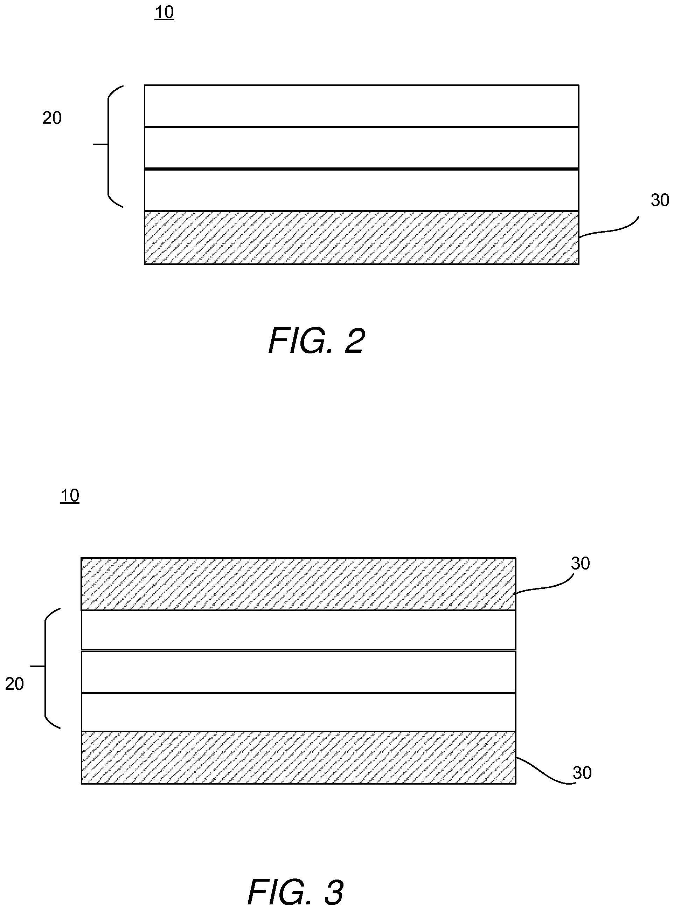

In a further aspect, a thin film device 10 can include the multi-layer thin film 20 and a release layer 30. The release layer 30 can change the optical properties and can incorporate functionalities to the thin film device 10. The release layer 30 can be present on one side of the multi-layer thin film 20 or can be present on both sides of the multi-layer thin film 20, as shown in FIGs. 2 and 3. If the release layer 30 is present on both sides of the multi-layer thin film 20, then each release layer 30 can be the same or different. For example, one release layer 30 can function as a release layer 30 in original contact with the web 40 and the second release layer 30 can provide additional functionalities to the thin film.

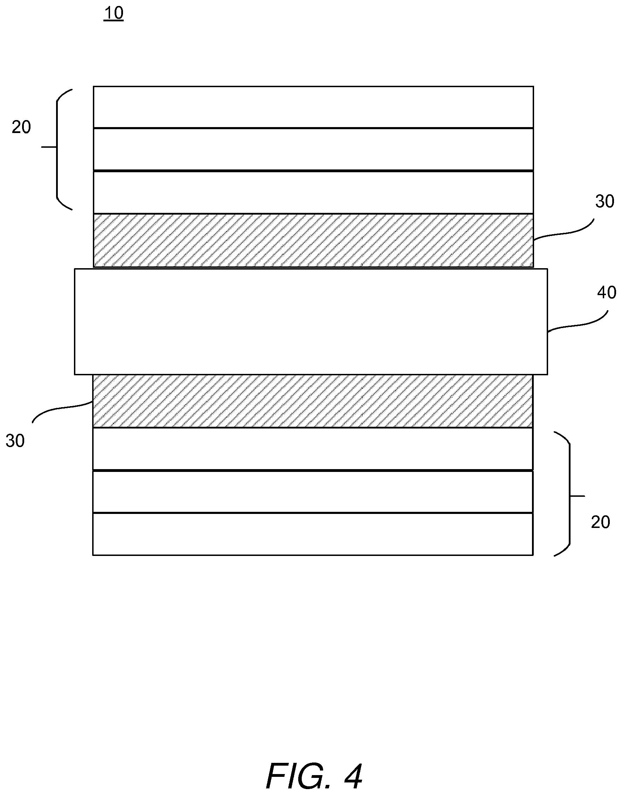

In an aspect, the release layer 30 can be coated on both sides of the web 40 to reduce manufacturing costs, as shown in FIG. 4. A first proposed manufacturing structure would resemble: multi-layer thin film/release layer/web/release layer/multi-layer thin film.

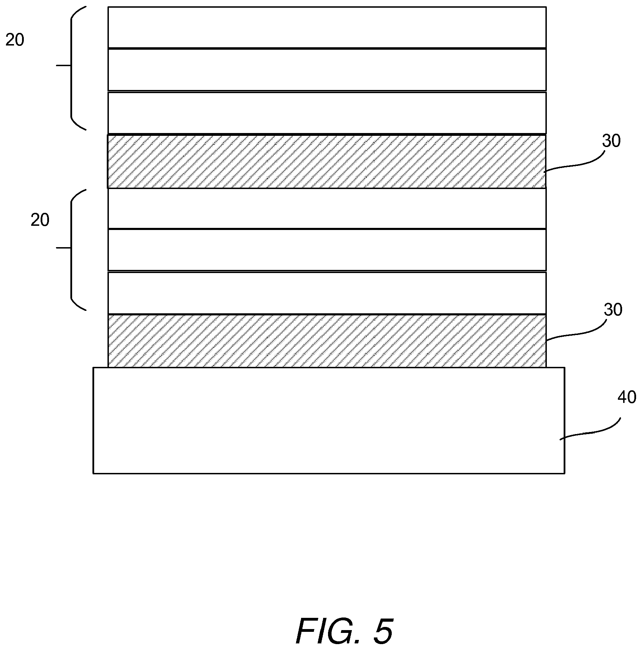

In a further aspect, a stack of release layers 30 and multi-layer thin films 20 can be formed on the web 40 to reduce manufacturing costs . A second proposed manufacturing structure would resemble: web/release layer/multi-layer thin film/release layer/ multi-layer thin film 20, as shown in FIG. 5. This can provide twice the amount of flakes from the same surface of web 40. Additionally, the first proposed (FIG. 4) and second proposed (FIG. 5) manufacturing structures can be combined to further decrease costs and to increase production.

### Example 1

A multi-layer thin film 20 including three layers was directly deposited onto a web 40 of PET, i.e., a release layer was not present. The multi-layer thin film 20 included a first organic layer of a composite hybrid acrylate-epoxy with an organic red colorant deposited using a slot die process. A reflector layer of aluminum was coated onto the first layer using vacuum deposition. A second layer was coated onto the reflector layer using a slot die process and including a composite hybrid acrylate-epoxy with an organic red colorant.

A mechanical force was applied to the multi-layer thin film 20 to release it from the web 40. The mechanical force included cracking of the multi-layer thin film 20 by applying tension to the web 40 with the assistance of a sharp knife in contact with the back of the web 40. The knife did not directly contact the multi-layer thin film 20 to avoid damage to the multi-layer thin film 20. The multi-layer thin film 20 coated on the web 40 was then exposed to a high flow/high velocity air flow to blow off the cracked coating. The application of the knife (cracking) and the application of the air were performed almost simultaneously. In this manner, the multi-layer thin film 20 was released from the web 40 and formed into thin film devices, such as flakes. The flakes were collected into a cyclone by an appropriate air-flow venting system. The flakes, i.e., the released multi-layer thin film 20, were ground using a jet mill grinding technology.

### Example 2

A multi-layer thin film 20 including three layers were directly deposited onto a web 40 of PET having a release layer 30 made of a water soluble polymeric formulation (PVA). The multi-layer thin film 20 included a first organic layer of a composite hybrid acrylate-epoxy with an organic red colorant deposited using a slot die process. A reflector layer of aluminum was coated onto the first layer using vacuum deposition. A second layer was coated onto the reflector layer using a slot die process and including a composite hybrid acrylate-epoxy with an organic red colorant.

A mechanical force was applied to the multi-layer thin film 20 to release it from the web 40. The mechanical force included cracking of the multi-layer thin film 20 by applying tension to the web 40 with the assistance of a sharp knife in contact with the back of the web 40. The knife did not directly contact the multi-layer thin film 20 to avoid damage to the multi-layer thin film 20. The multi-layer thin film 20 coated on the web 40 was then exposed to a high flow/high velocity air flow to blow off the cracked coating. The application of the knife (cracking) and the application of the air were performed almost simultaneously. In this manner, the multi-layer thin film 20 was released from the web 40 and formed into thin film devices, such as flakes. The flakes were collected into a cyclone by an appropriate air-flow venting system. The flakes, i.e., the released multi-layer thin film 20, were ground using a jet mill grinding technology.

### Example 3

A five-layer thin film was formed based on a third layer of chromium, a first layer of zinc sulfide, a reflector layer of aluminum, a second layer of zinc sulfide, and a fourth layer of chromium. The multi-layer thin film 20 had an optical thickness of the zinc sulfide dielectric layers (first layer and second layer) to produce a non- or slow green color shifting design. The first layer and the second layer were vacuum physical vapor deposited using a box coater on a PET web 40. The PET web 40 included a release layer 30 of PVA (60 to 200 nm). The PVA release layer 30 was air strippable and water-soluble. The green multi-layer thin film 20 had the following structure: 8 nm Cr/368 nm ZnS/80 nm Al/368 nm ZnS/8 nm Cr.

### Example 4

A five-layer thin film interference was formed based on a third layer of chromium, a first layer of magnesium fluoride, a reflector layer of aluminum, a second layer of magnesium fluoride, and a fourth layer of chromium. The multi-layer thin film 20 had an optical thickness of the magnesium fluoride dielectric layers (first layer and second layer) to produce a red/gold color shifting design. The first layer and the second layer were roll to roll vacuum physical vapor deposited on a PET web 40. The PET web 40 included a release layer 30 of PVA with different thicknesses (60 to 200 nm). The PVA layers were coated using a K101 Control K-Hand Coater using K-Bars number 0, 2, and 5 which correspond to wet thicknesses of 4, 12, and 50 microns, respectively. In all cases, the PVA coating formulation had 2.2% solid, the dry physical thickness of the PVA layers were 88 nm, 264 nm, and 1100 nm, respectively. The multi-layer with the three PVA release layers 30 were air strippable and water-soluble. The thicker PVA layers tended to make the air stripping process more efficient. The red/gold multi-layer thin film 20 had the following structure: 10 nm Cr/250 nm MgF₂/80 nm Al/250 nm MgF₂/10 nm Cr.

A method of forming a thin film device, comprising: providing a web with a water-soluble release layer; coating the water-soluble release layer with a multi-layer thin film; and applying a mechanical force to release the multi-layer thin film from the web. The method of claim 18, wherein the multi-layer thin film includes a Fabry-Perot structure. The method of claim 18, wherein the multi-layer thin film includes a first layer coated on the water-soluble release layer; coating the first layer with a reflector layer; and coating the reflector layer with a second layer to form the multi-layer thin film. The method of claim 18, wherein the release layer is chosen from polyvinyl alcohol formulation, polysaccharide formulation, polyacrylic acid formulation, polyvinyl acetate formulation, polyvinyl pyrrolidone formulation, carboxymethyl cellulose formulation, and combinations thereof.

From the foregoing description, those skilled in the art can appreciate that the present teachings can be implemented in a variety of forms. Therefore, while these teachings have been described in connection with particular embodiments and examples thereof, the true scope of the present teachings should not be so limited. Various changes and modifications may be made without departing from the scope of the teachings herein.

This scope disclosure is to be broadly construed. It is intended that this disclosure disclose equivalents, means, systems and methods to achieve the devices, activities and mechanical actions disclosed herein. For each device, article, method, mean, mechanical element or mechanism disclosed, it is intended that this disclosure also encompass in its disclosure and teaches equivalents, means, systems and methods for practicing the many aspects, mechanisms and devices disclosed herein. Additionally, this disclosure regards a coating and its many aspects, features and elements. Such a device can be dynamic in its use and operation, this disclosure is intended to encompass the equivalents, means, systems and methods of the use of the device and/or article of manufacture and its many aspects consistent with the description and spirit of the operations and functions disclosed herein. The claims of this application are likewise to be broadly construed.

The description of the inventions herein in their many embodiments is merely exemplary in nature and, thus, variations that do not depart from the gist of the invention are intended to be within the scope of the invention. Such variations are not to be regarded as a departure from the spirit and scope of the invention.

## Claims

1. A method of forming a thin film device, comprising:
coating a web with a multi-layer thin film; and
applying a mechanical force to release the multi-layer thin film from the web.

2. The method of claim 1, wherein the multi-layer thin film includes 3 layers.

3. The method of claim 1, wherein the multi-layer thin film includes a Fabry-Perot structure.

4. A method of forming a thin film device, comprising:
coating a web with a first layer;
coating the first layer with a reflector layer;
coating the reflector layer with a second layer to form a multi-layer thin film; and
releasing the multi-layer thin film from the web by a dry technique.

5. The method of claim 4, further comprising collecting the released multi-layer thin film.

6. The method of claim 4, further comprising grinding the released multi-layer thin film.

7. The method of claim 4, wherein the first layer and the second layer are each independently an organic layer or a composite organic/inorganic layer.

8. The method of claim 4, wherein the dry technique is an applied mechanical force creating a localized tension to crack the multi-layer thin film followed by application of a high velocity gas, air, or steam.

9. The method of claim 4, wherein the dry technique is an applied mechanical force of a localized ultrasonic application.

10. The method of claim 4, wherein the dry technique is an applied mechanical force of directly pulling the multi-layer thin film from the web.

11. The method of claim 4, wherein the dry technique is an applied mechanical force of stretching the multi-layer thin film while a vibrational force is applied.

12. The method of claim 4, wherein the dry technique is an applied mechanical force of vacuuming to strip the multi-layer thin film off the web by placing a vacuum blade in close proximity.

13. The method of claim 4, wherein each coating is independently applied using a process chosen from slot-die, gravure, microgravure, inkjet, curtain coating, metering rod, myer bar coating, flexo, and offset printing.

14. The method of claim 4, wherein each coating is independently applied using a process under vacuum chosen from physical vapor deposition and chemical vapor deposition.

15. The method of claim 4, wherein the first layer and the second layer are applied using a process chosen from slot-die, gravure, microgravure, inkjet, curtain coating, metering rod, myer bar coating, flexo, and offset printing, and the reflector layer is applied using a process under vacuum chosen from physical vapor deposition and chemical vapor deposition.
